# EUROPEAN PATENT APPLICATION

(11) **EP 2 416 352 A2**
(43) Date of publication of application: **08.02.2012**
(21) Application number: 11172625.3
(22) Date of filing: 05.07.2011
(51) Int. Cl.: H01L 21/336, H01L 21/02

(54) **Methods for fabricating trench metal oxide semiconductor field effect transistors**

(30) Priority: 02.08.2010 US 369961 P; 27.06.2011 US 170023
(71) Applicant: O2 Micro, Inc., Santa Clara, CA 95054 (US)
(72) Inventor: Lu, Hamilton, Los Angeles, CA 90066 (US); Lipcsei, Laszlo, Campbell, CA 95008 (US)
(74) Representative: Lippert, Stachow & Partner

(57) **Abstract**

A trench metal oxide semiconductor field effect transistor (MOSFET) can be fabricated in an upward direction. A trench bottom doping (TBD) process and/or a trench bottom oxide (TBO) process can be performed after formation of a substrate and a first epitaxial (epi) layer. Poly seal can be performed after the formation of TBO layers and before a merged epitaxial lateral overgrowth (MELO) step to improve quality and purity of a second epi layer formed in the MELO step. Plasma dry etching with an end point mode can be performed according to the locations of TBO layers to improve the uniformity of trench depth.

## Description

### RELATED APPLICATION

This application claims priority to U.S. Provisional Application No. 61/369,961, titled "Methods for Fabricating Trench Metal Oxide Semiconductor Field Effect Transistors," filed on August 2, 2010, which is hereby incorporated by reference in its entirety.

### BACKGROUND

During the past few decades, there has been an increasing interest in semiconductor devices, such as power metal oxide semiconductor field effect transistors (MOSFETs) used in various applications. Planar MOSFETs became available in the mid-1970s. By the late 1980s, trench MOSFETs started penetrating power MOSFET markets utilizing dynamic random access memory (DRAM) trench technology, which has improved the specific on-resistance between drain and source (RDSON).

The trench MOSFET has a major advantage over the planar MOSFET in terms of current densities due to the benefits of a vertical channel for better cell pitch. However, the trench MOSFET suffers from high gate drain charges Q_{GD}. The high Q_{GD} can limit the power supply ability of the trench MOSFET. Take a conventional W-gated trench MOSFET (MOSFET) as an example. A trench bottom oxide (TBO) structure can be achieved by conventional local oxidation of silicon (LOCOS) technology to reduce the Q_{GD} of the WMOSFET. However, the stress ofTBO in the WMOSFET created from the LOCOS technology, including the known bird's beak effect, introduces a long-term reliability problem. Poor trench depth uniformity from the center of wafers to the edges of wafers also affects the parameters of the WMOSFET such as the sigma of RDSON, the breakdown voltage (BV), etc. The trench bottom implantation through a curved bottom surface, called trench bottom doping (TBD), creates a fluctuating doping profile and shape underneath the TBO region, which makes parameters such as RDSON and BV hard to control. Additionally, multiple trench bottom implantations are required to achieve the correct implant profiles, which complicates processing and increases cost. The fabrication processes of the trench MOSFET are performed downward and it is hard to control the thickness and the implant profile of each layer during the fabrication.

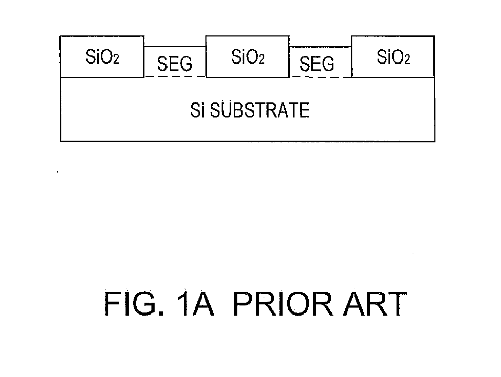

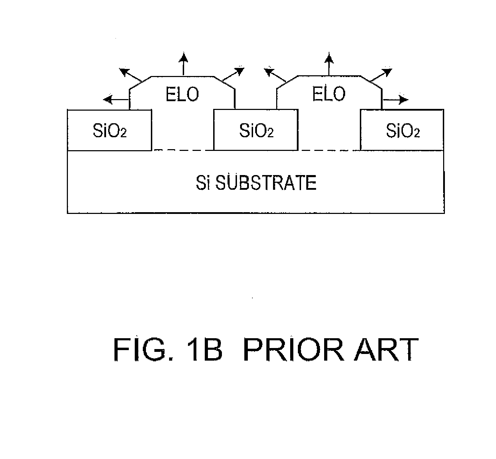

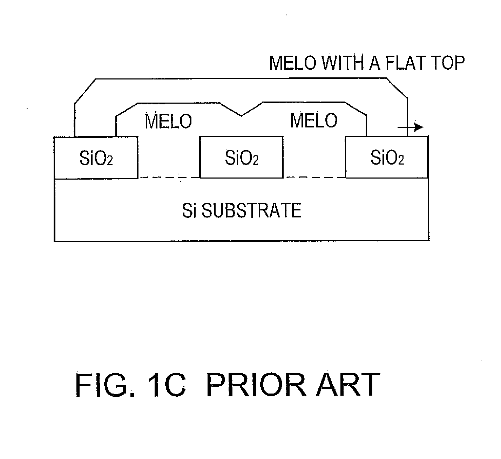

FIGs. 1A-1C illustrate cross-sectional views of structure diagrams of epitaxial (epi) options over patterned oxide atop substrates for conventional MOSFETs. In the early 1970s, a selective epitaxial growth (SEG) of silicon and gallium arsenide was utilized as shown in FIG. 1A. Later, many applications replaced SEG with epitaxial lateral overgrowth (ELO) and merged epitaxial lateral overgrowth (MELO), shown in FIG. 1B and FIG. 1C, respectively. The SEG technology shown in.FIG. 1A, the ELO technology shown in FIG. 1B, and the MELO technology shown in FIG. 1C have poor single crystal silicon quality due to oxygen impurity, which limits the applications of devices and integrated circuits (ICs) fabricated on this kind of epi silicon on insulator (SOI) structure.

### SUMMARY

In one embodiment, a trench metal oxide semiconductor field effect transistor (MOSFET) is fabricated in an upward direction. A trench bottom doping (TBD) process and/or a trench bottom oxide (TBO) process are performed after formation of a substrate and a first epitaxial (epi) layer. Poly seal is performed after the formation of TBO layers and before a merged epitaxial lateral overgrowth (MELO) step to improve quality and purity of a second epi layer formed in the MELO step. Plasma dry etching with an end point mode is performed according to the locations of TBO layers to improve the uniformity of trench depth.

### BRIEF DESCRIPTION OF THE DRAWINGS

Features and advantages of embodiments of the disclosed subject matter will become apparent as the following detailed description proceeds, and upon reference to the drawings, wherein like numerals depict like parts, and in which:

FIGs. 1A-1C illustrate cross-sectional views of structure diagrams of epitaxial options over patterned oxide atop substrates for conventional metal oxide semiconductor field effect transistors (MOSFETs).

FIGs. 2,A-2F illustrate cross-sectional views of a fabrication sequence of a trench MOSFET, in accordance with one embodiment of the present invention.

FIGs. 3A-3I illustrate cross-sectional views of a fabrication sequence of a trench MOSFET, in accordance with another embodiment of the present invention.

FIGs. 4A-4I illustrate cross-sectional views of a fabrication sequence of a trench MOSFET, in accordance with yet another embodiment of the present invention.

FIGs. 5A-5F illustrate cross-sectional views of a fabrication sequence of a trench MOSFET, in accordance with yet another embodiment of the present invention.

FIG. 6 illustrates a block diagram of a power conversion system, in accordance with one embodiment of the invention.

### DETAILED DESCRIPTION

In the following detailed description of the present invention, numerous specific details are set forth in order to provide a thorough understanding of the present invention. However, it will be recognized by one skilled in the art that the present invention may be practiced without these specific details or with equivalents thereof. In other instances, well-known methods, procedures, components, and circuits have not been described in detail as not to unnecessarily obscure aspects of the present invention.

Some portions of the detailed descriptions that follow are presented in terms of procedures, logic blocks, processing, and other symbolic representations of operations for fabricating semiconductor devices. These descriptions and representations are the means used by those skilled in the art of semiconductor device fabrication to most effectively convey the substance of their work to others skilled in the art. In the present application, a procedure, logic block, process, or the like, is conceived to be a self-consistent sequence of steps or instructions leading to a desired result. The steps are those requiring physical manipulations of physical quantities. It should be borne in mind, however, that all of these and similar terms are to be associated with the appropriate physical quantities and are merely convenient labels applied to these quantities. Unless specifically stated otherwise as apparent from the following discussions, it is appreciated that throughout the present application, discussions utilizing terms such as "constituting," "depositing," "oxidizing," "etching," "fabricating," "forming," "implanting," "metalizing" or the like, refer to actions and processes of semiconductor device fabrication.

It is understood that the figures are not drawn to scale, and only portions of the structures depicted, as well as the various layers that form those structures, may be shown.

Furthermore, other fabrication processes and steps maybe performed along with the processes and steps discussed herein; that is, there maybe a number of processes and steps before, in between and/or after the steps shown and described herein. Importantly, embodiments of the present invention can be implemented in conjunction with these other processes and steps without significantlyperturbing them. Generally speaking, the various embodiments of the present invention can replace portions of a conventional process without significantly affecting peripheral processes and steps.

Embodiments according to the present invention provide methods for fabricating a trench metal oxide semiconductor field effect transistor (MOSFET) in an upward direction relative to the substrate. The upward technology makes parameters of each layer easier to control without extra fabrication steps. A trench bottom doping (TBD) process and/or a trench bottom oxide (TBO) process are performed on a partial thickness of an epitaxial (epi) layer atop a substrate. Afterwards, a merged epitaxial lateral overgrowth (MELO) step is performed to grow the rest of the epi thickness. Hence, no stress and no extra fabrication steps are introduced at the oxidation of the partial epi layer, and the oxide thickness can be grown much thicker without stress compared with conventional LOCOS technologies and/or conventional downward fabrication technologies. Also, it is easier to achieve a predetermined uniform trench depth, a thicker TBO layer without stress, and a uniform epi thickness across the entire epi layer, which are crucial characteristics for the trench MOSFET..

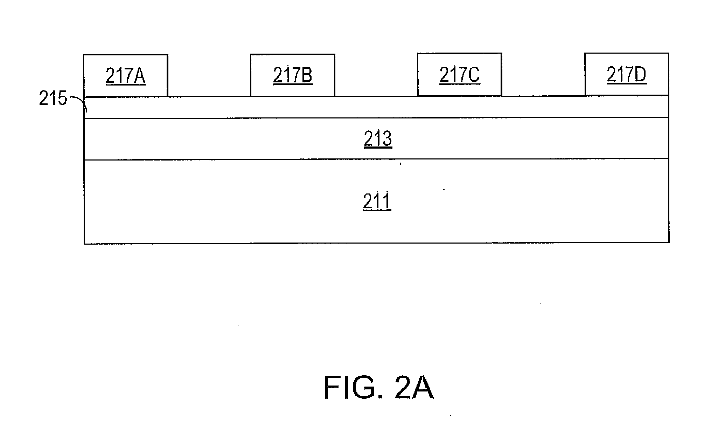

FIGs. 2A-2F illustrate cross-sectional views of a fabrication sequence of a trench metal oxide semiconductor field effect transistor (MOSFET), in accordance with one embodiment of the present invention. The process shown in FIGs. 2A-2F is for illustrative purposes and is not intended to be limiting.

In FIG. 2A, epitaxial (epi) deposition is performed to form an epi layer on the top of a semiconductor substrate 211 of a wafer. In one embodiment, the thickness of the epi layer is approximately two (2) µm. The semiconductor substrate 211 as a bottom layer can constitute a drain region of the trench MOSFET. Then, a partial thickness of the epi layer is oxidized to produce a predetermined TBO thickness, e.g., 1000-5000A. As a result, an epi layer 213 is formed and an oxide layer 215 is formed. The thickness of the epi layer 213 is less than 2 µm. Afterwards, a first photoresist is deposited to form photoresist regions 217A-217D. The photoresist regions 217A-217D act as soft masks to pattern trench areas for the trench MOSFET, e.g., the locations for the trenches of the trench MOSFET.

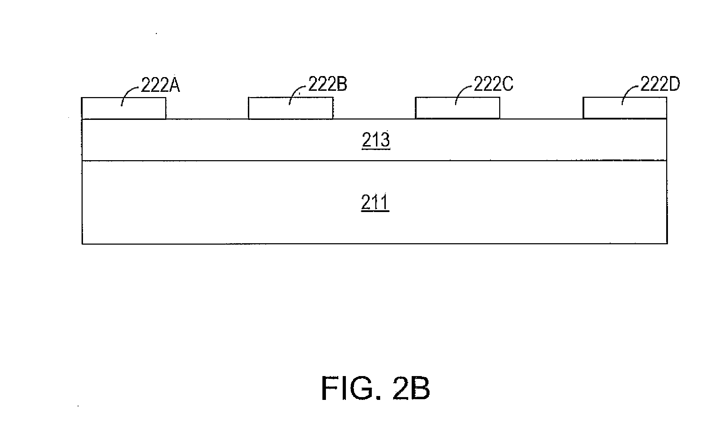

In FIG. 2B, oxide windows, e.g., part of the oxide layer 215, are etched away to form oxide layers 222A-222D, and then the first photoresist is removed. Consequently, a trench bottom oxide (TBO) process is performed in FIG. 2A and FIG. 2B.

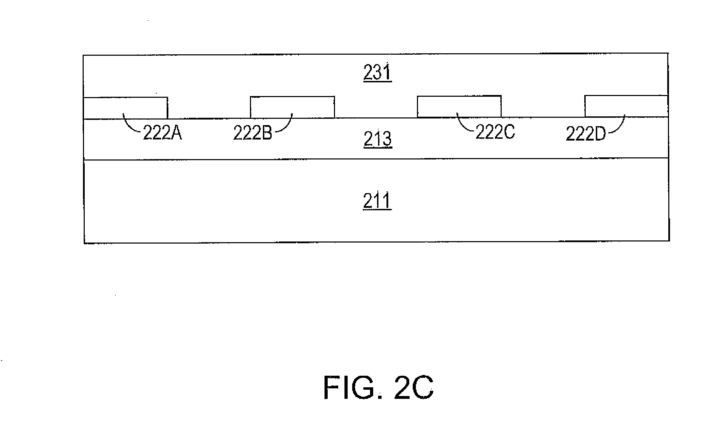

In FIG. 2C, a merged epitaxial lateral overgrowth (MELO) step is performed to grow the rest of the epi thickness of the trench MOSFET. As a result, it is easier to achieve a predetermined epi thickness for the trench MOSFET due to the upward technology. Hence, an epi layer 231 is formed to surround the oxide layers 222A-222D as Si seeds. In one embodiment, the epi thickness is grown to thicker than five (5) µm until the total epi thickness can grow to about seven (7) µm to meet a thickness that can sustain a breakdown voltage (BV) of the trench MOSFET.

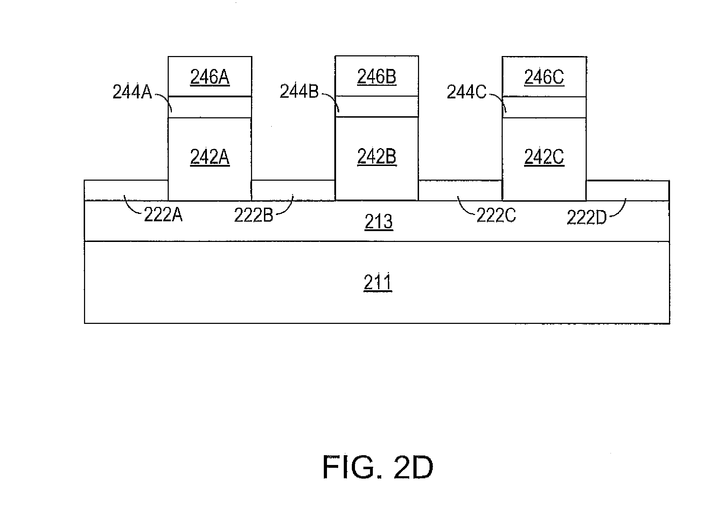

In FIG. 2D, hard mask oxidation is performed on the top of the epi layer 213 to form an oxide layer which is grown to about 200-1000A. Afterwards, a second photoresist is deposited to pattern the oxide layer, and photoresist regions 246A-246C are formed atop the oxide layer and pattern the locations for the trenches of the trench MOSFET. The edges of the photoresist regions 246A-246C are aligned to the edges of the oxide layers 222A-222D. Plasma dry etching with an end point mode is performed to remove the silicon and the oxide from part of the epi layer 231 and from part of the oxide layer to form epi layers 242A-242C and oxide layers 244A-244C. More specifically, end points for the trench etching are preset according to the locations of TBO layers, e.g., the oxide layers 222A-222C. When an intelligent sensor (not shown) detects that the etching location reaches the end points, the plasma dry etching is stopped. Hence, the trenches of the trench MOSFET are formed. Advantageously, by using end points to etch the trenches, variations in the uniformity of trench depth across the wafer will be significantly reduced to less than (<) 1 % compared with variations of greater than (>) 10% experienced with a conventional timed trench etching mode.

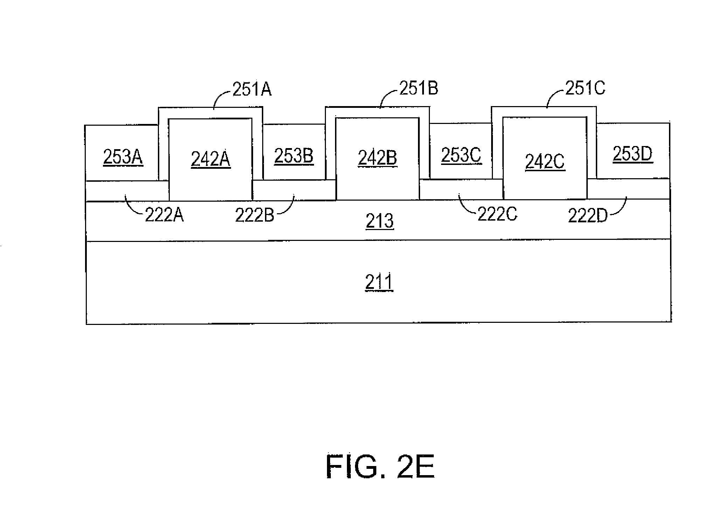

In FIG. 2E, after the second photoresist is stripped from the wafer's surface, a sacrificial oxide layer is grown thermally on the top of the oxide layers 222A-222D and 244A-244C. Then the sacrificial oxide layer and the oxide layers 244A-244C are stripped away by wet buffered oxide etching (BOE) to remove surface defects and smooth surface roughness. Gate oxidation is performed surrounding the epi layers 242A-242C to form gate oxide layers 251A-251C with a predetermined thickness. Then, poly film is deposited with doping in-situ or ex-situ to form polysilicon layers. The polysilicon layers are etched back with an end point mode. Hence, slight poly recess etching is performed to form polysilicon layers 253A-253D. As a result, the trenches are filled with the polysilicon layers 253A-253D with a predetermined thickness.

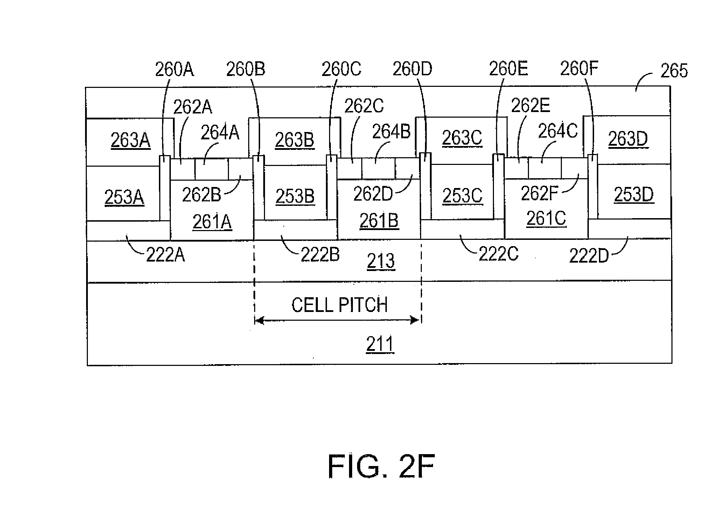

In FIG. 2F, P-type dopants or N-type dopants for the channel body (n-channel or p-channel trench MOSFET, respectively) are implanted and driven in the epi-layers 242A-242C to form P-wells or N-wells 261A-261C. The P-wells or N-wells 261A-261C can form body regions of the trenches. Then, N-type dopants are implanted and driven in to form N-type heavily doped (N+) layers 262A-262F. Borophosphorosilicate glass (BPSG) is deposited to form BPSG layers 263A-263D atop the gate oxide layers 260A-260F. Subsequently, an implantation of P-type dopants followed by a drive-in step, an etching step, and an anneal step is performed to form P-type heavily doped (P+) layers 264A-264C adjacent to the N+ layers 262A-262F. The N+ layers 262A-262F can form source regions of the trench MOSFET. Metallization is performed to separate gate and source metal connections. The entire trench MOSFET can be metalized by a metal layer 265. Then, passivation is performed to isolate the trench MOSFET from the external environment.

Advantageously, the fabrication processes of the trench MOSFET are performed upward, and hence it is easier to control the implant profile, shape, and thickness of each layer of the trench MOSFET. As a result, repetitive processes to achieve the predetermined profile, shape, and thickness of each layer can be avoided, and the simpler processes can reduce the cost of fabricating the trench MOSFET. Additionally, the quality and purity of each layer can be also improved.

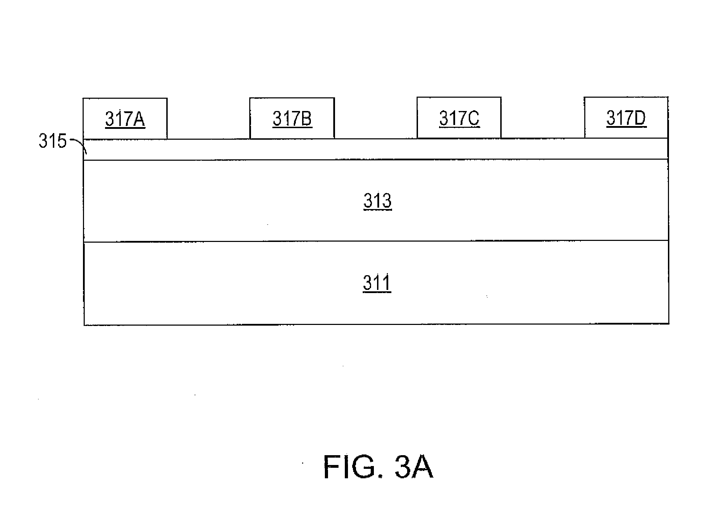

FIGs. 3A-3I illustrate cross-sectional views of a fabrication sequence of a trench MOSFET, in accordance with another embodiment of the present invention.

In FIG. 3A, epitaxial (epi) deposition is performed to form an epi layer on the top of a semiconductor substrate 311 of a wafer. The semiconductor substrate 311 as a bottom layer can constitute a drain region of the trench MOSFET. A partial thickness of the epi layer is oxidized, e.g., the oxide thickness can be 200-1000A. As a result, an oxide layer 315 is formed atop an epi layer 313. Afterwards, a first photoresist is deposited to form photoresist regions 317A-317D.The photoresist regions 317A-317D act as soft masks to pattern trench areas for the trench MOSFET, e.g., the locations for the trenches of the trench MOSFET.

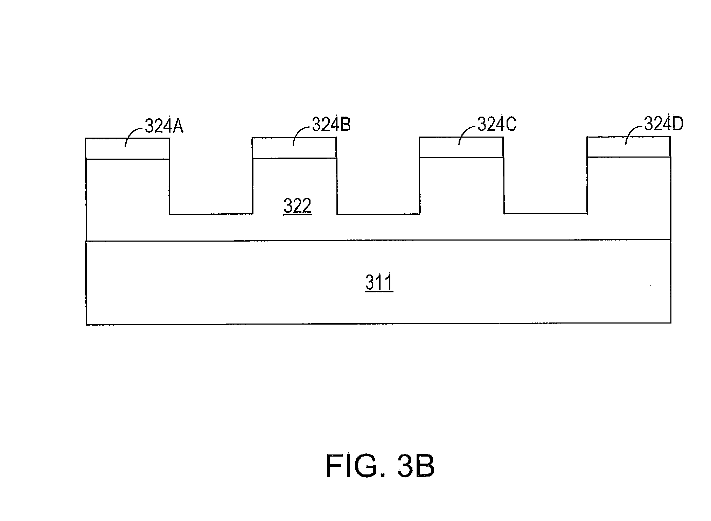

In FIG. 3B, oxide windows, e.g., part of the oxide layers 315, and silicon trenches, e.g., part of the epi layer 313, are etched away to form oxide layers 324A-324D and an epi layer 322. Then the first photoresist is removed.

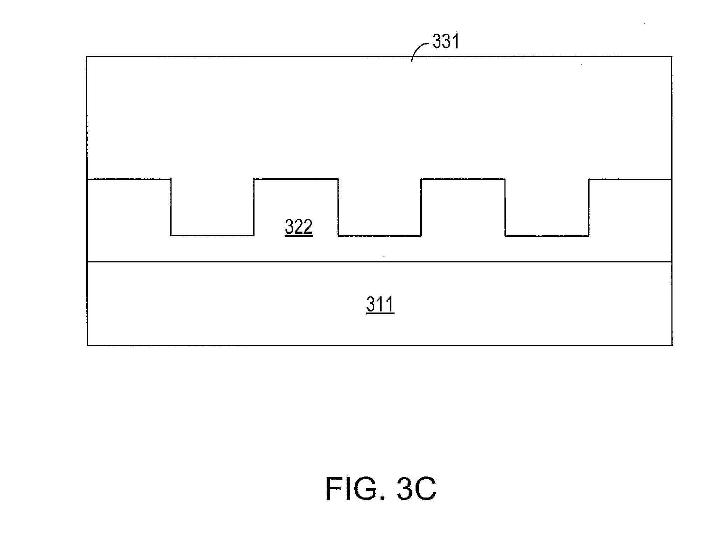

In FIG. 3C, chemical vapor deposition (CVD) oxide is deposited to form an oxide layer 331 in one embodiment. In another embodiment, tetraethylorthosilicate (TEOS) is deposited to form the oxide layer 331.

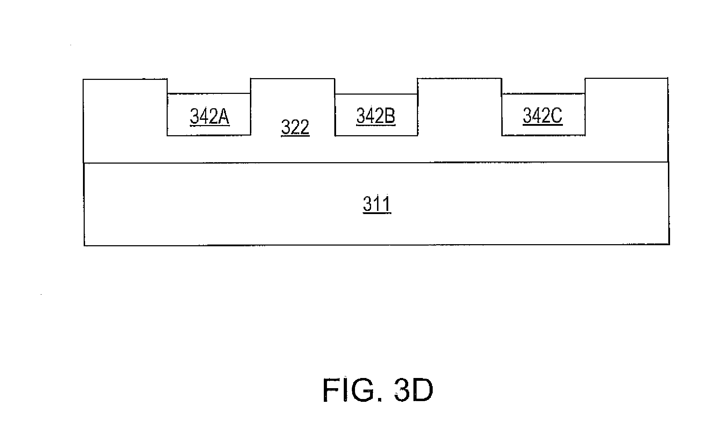

In FIG. 3D, the oxide layer 331 is etched back with an end point mode. Hence, trench recess etching is performed to form oxide layers 342A-342C. Consequently, a trench bottom oxide (TBO) process is performed in FIG. 3C-FIG. 3D.

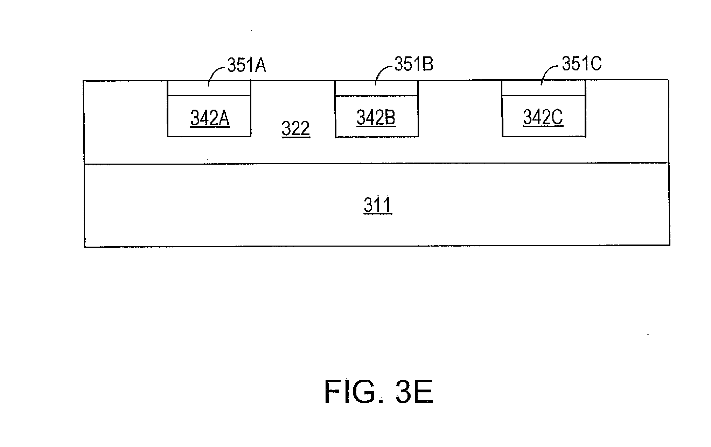

In FIG. 3E, poly film is deposited and etched back to form polysilicon layers 351A-351C in the trench areas of the trench MOSFET.

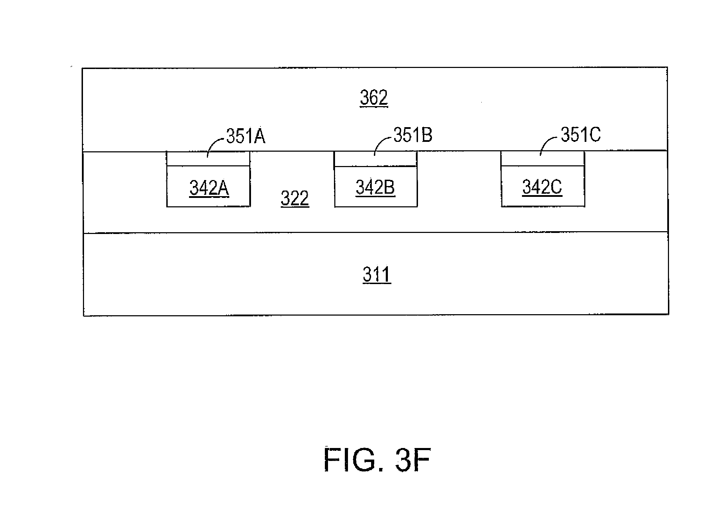

In FIG. 3F, a MELO step is performed to achieve the rest of the epi thickness of the trench MOSFET. As a result, due to the upward technology, the predetermined epi thickness for the trench MOSFET is easier to achieve to sustain a BV of the trench MOSFET. An epi layer 362 is formed atop the polysilicon layers 351A-351C. The polysilicon layers 351A-351C act as caps atop the oxide layers 342A-342C to seal out oxygen gas in the MELO step, which will reduce the number of oxygen atoms incorporated into the Si epi process and improve the quality of the epi layer 362.

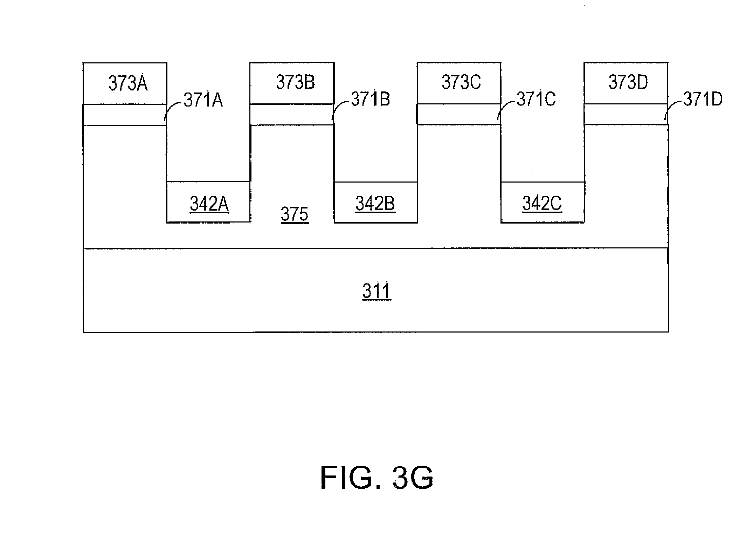

In FIG. 3G, hard mask oxidation is performed on the top of the epi layer 362 to form an oxide layer which is grown to about 200-1000A as a hard mask oxide. Afterwards, a second photoresist is deposited to pattern the oxide layer, and photoresist regions 373A-373D are formed atop the oxide layer and pattern the locations for the trenches of the trench MOSFET. The edges of the photoresist regions 373A-373D are aligned to the edges of the oxide layers 342A-342D. Plasma dry etching with an end point mode is performed to remove the hard mask oxide and the silicon from part of the oxide layer and from part of the epi layer 362 to construct stacks of an epi layer 375 and oxide layers 371A-371D. At the same time, the polysilicon layers 351A-351C are etched away. Hence, the trenches for the trench MOSFET are formed. Advantageously, variations in the uniformity of trench depth across the wafer can be reduced to, e.g., less than 1%.

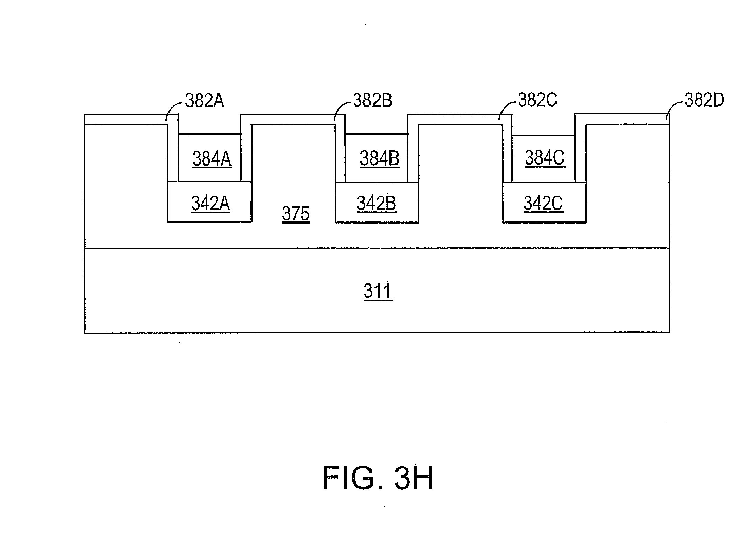

In FIG. 3H, after the second photoresist is stripped from the wafer's surface, a sacrificial oxide layer is grown thermally on the top of the oxide layers 342A-342C and 371A-371D. Then the sacrificial oxide layer and the oxide layers 371A-371D are stripped away by wet buffered oxide etching (BOE) to remove surface defects and smooth surface roughness. Gate oxidation is performed surrounding the epi layer 375 to form gate oxide layers 382A-382D with a predetermined thickness. Then, poly film is deposited with doping in-situ or ex-situ to form polysilicon layers. The polysilicon layers are etched back with an end point mode. Hence, slightly poly recess etching is performed to form polysilicon layers 384A-384C. As a result, the trenches are filled with the polysilicon layers 384A-384C with a predetermined thickness.

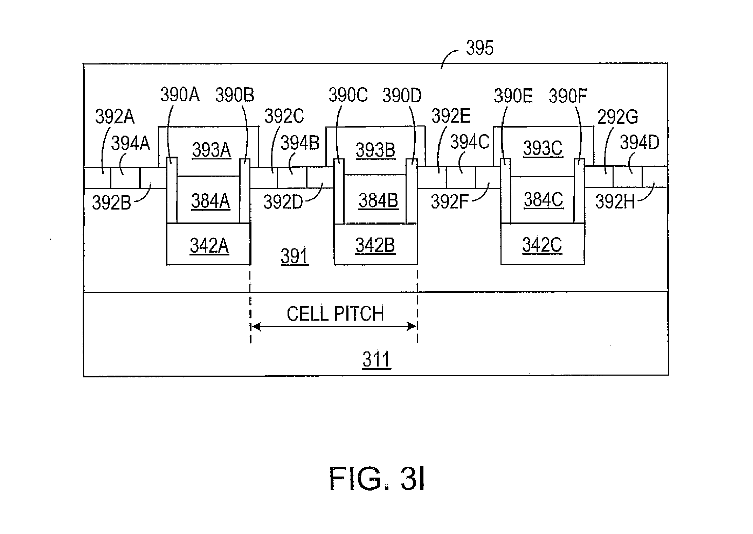

In FIG. 3I, P-type dopants or N-type dopants for the channel body (n-channel or p-channel trench MOSFET, respectively) are implanted and driven in the epi-layer 375 to form a P-well or N-well 391. The P-well or N-well 391 can form a body region of the trenches. Then, N-type dopants are implanted and driven in to form N+ layers 392A-392H. BPSG is deposited to form BPSG layers 393A-393C atop gate oxide layers 390A-390F. Subsequently, an implantation of P-type dopants followed by a drive-in step, an etching step, and an anneal step is performed to form P+ layers 394A-394D adjacent to the N+ layers 392A-392H. The N+ layers 392A-392H can form source regions of the trench MOSFET. Metallization is performed to separate gate and source metal connections. The entire trench MOSFET can be metalized by a metal layer 395. Then, passivation is performed to isolate the trench MOSFET from the external environment.

Advantageously, the upward fabrication processes of the trench MOSFET make the parameters, e.g., the implant profile, shape and thickness, of each layer easier to control. Hence, extra fabrication steps are avoided, the cost of fabricating the trench MOSFET is reduced, and the quality and purity of each layer are improved.

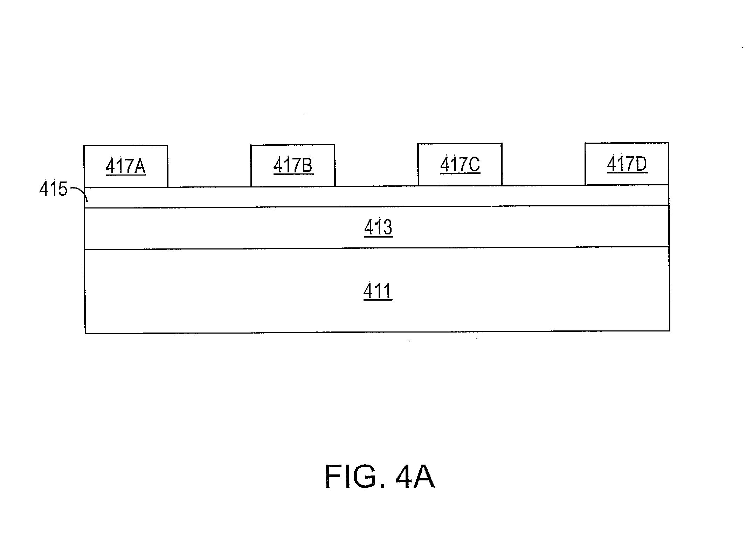

FIGs. 4A-4I illustrate cross-sectional views of a fabrication sequence of a trench MOSFET, in accordance with yet another embodiment of the present invention.

In FIG. 4A, epitaxial (epi) deposition is performed to form an epi layer on the top of a semiconductor substrate 411 of a wafer. The semiconductor substrate 411 as a bottom layer can constitute a drain region of the trench MOSFET. Partial thickness of the epi layer is oxidized, e.g., the oxide thickness can be 200-1000A. As a result, an oxide layer 415 is formed atop an epi layer 413. Afterwards, a first photoresist is deposited to form photoresist regions 417A-417D. The photoresist regions 417A-417D act as soft masks to pattern trench areas for the trench MOSFET, e.g., the locations for the trenches of the trench MOSFET.

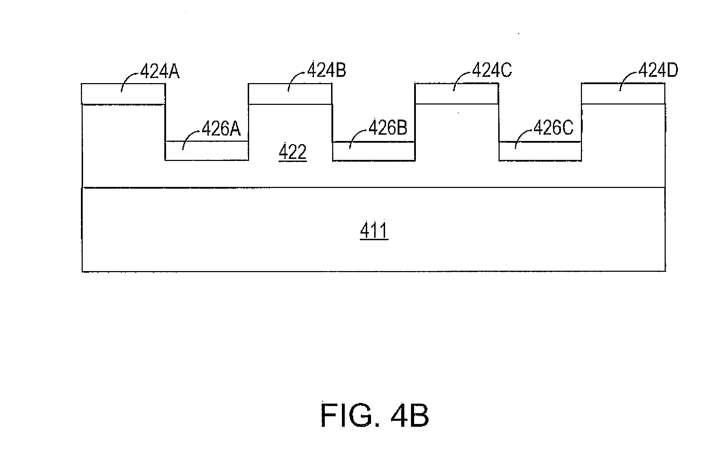

In FIG. 4B, oxide windows, e.g., part of the oxide layers 415, and silicon trenches, e.g., part of the epi layer 413, are etched away to form oxide layers 424A-424D and an epi layer 422. Then, the first photoresist is removed. Afterward, N+ doping materials, e.g., polysilicon or spin-on phosphorus glass, are deposited and etched back to form N+ layers 426A-426C. Consequently, a trench bottom doping (TBD) process is performed in FIG. 4B.

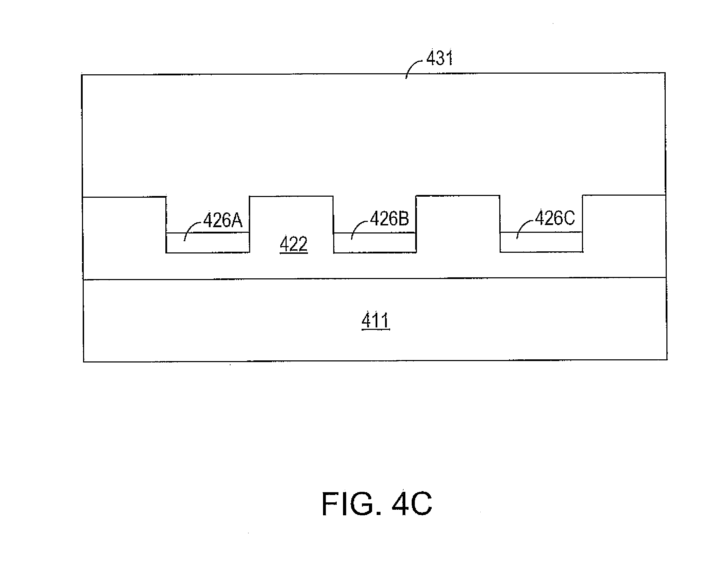

In FIG. 4C, chemical vapor deposition (CVD) oxide is deposited to form an oxide layer 431 in one embodiment. In another embodiment, tetraethylorthosilicate (TEOS) is deposited to form the oxide layer 431.

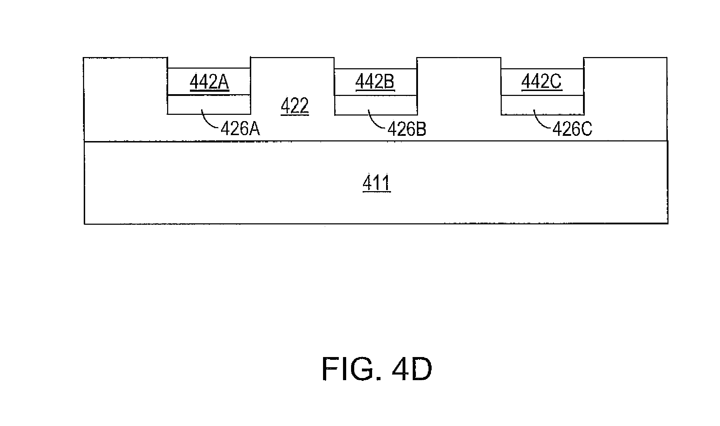

In FIG. 4D, the oxide layer 431 is etched back with an end point mode. Hence, trench recess etching is performed to form oxide layers 442A-442C. Consequently, a trench bottom oxide (TBO) process is performed in FIG. 4C-FIG. 4D.

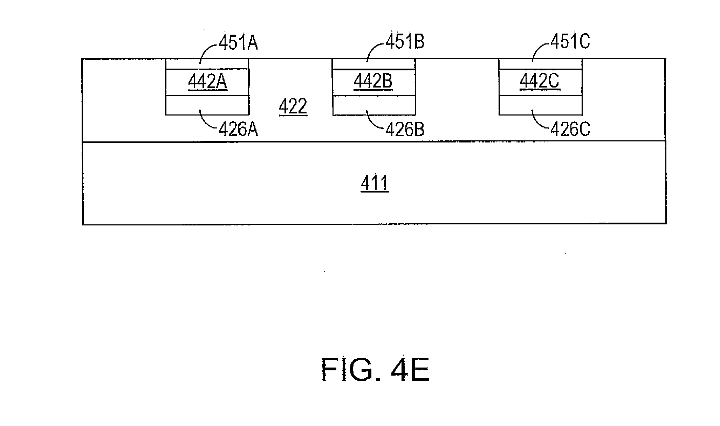

In FIG. 4E, poly film is deposited and etched back to form polysilicon layers 451A-451C in the trench areas of the trench MOSFET.

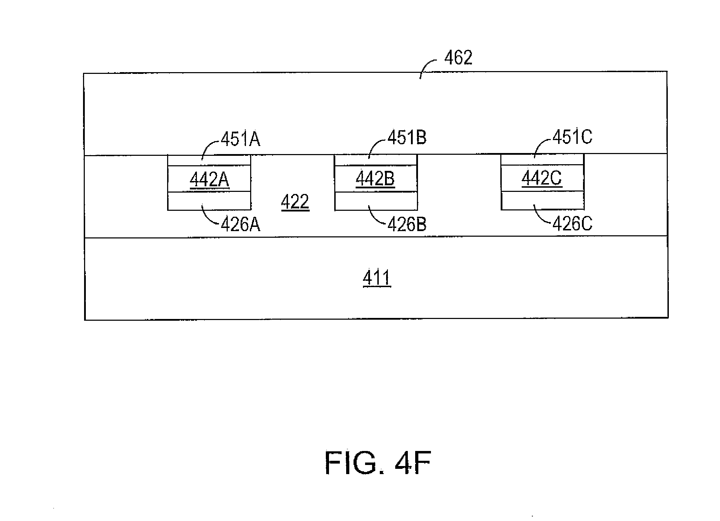

In FIG. 4F, a MELO step is performed to achieve the rest of the epi thickness of the trench MOSFET. As a result, due to the upward technology, the predetermined epi thickness for the trench MOSFET is easier to achieve to sustain a BV of the trench MOSFET. An epi layer 462 is formed atop the polysilicon layers 451A-451C. The polysilicon layers 451A-451C act as caps atop the oxide layers 442-442C to seal out oxygen gas in the MELO step. Advantageously, the quality of the epi layer 462 is improved.

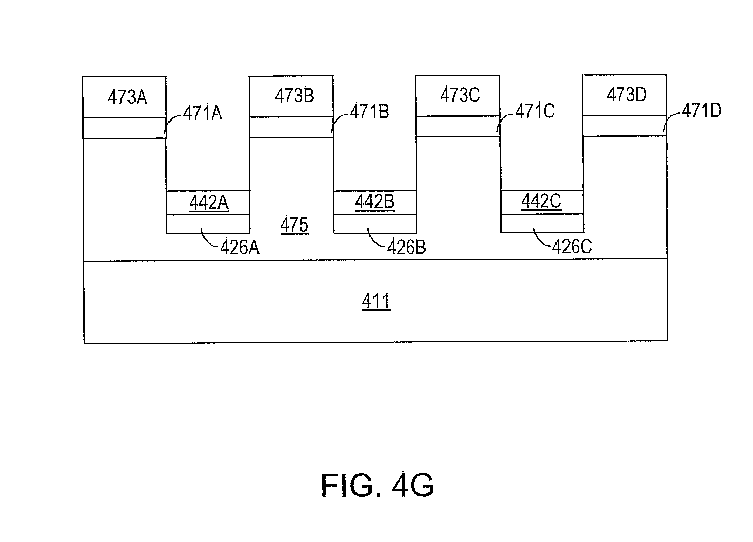

In FIG. 4G, hard mask oxidation is performed on the top of the epi layer 462 to form an oxide layer which is grown to about 200-1000A as hard mask oxide. Afterwards, a second photoresist is deposited to pattern the oxide layer, and photoresist regions 473A-473D are formed atop the oxide layer and pattern the locations for the trenches of the trench MOSFET. The edges of the photoresist regions 473A-473D are aligned to the edges of the oxide layers 442A-442D. Plasma dry etching with an end point mode is performed to remove the hard mask oxide and the silicon from part of the oxide layer and from part of the epi layer 462 to construct stacks of an epi layer 475 and oxide layers 471A-471D. At the same time, the polysilicon layers 451A-451C are etched away. Hence, the trenches for the trench MOSFET are formed.

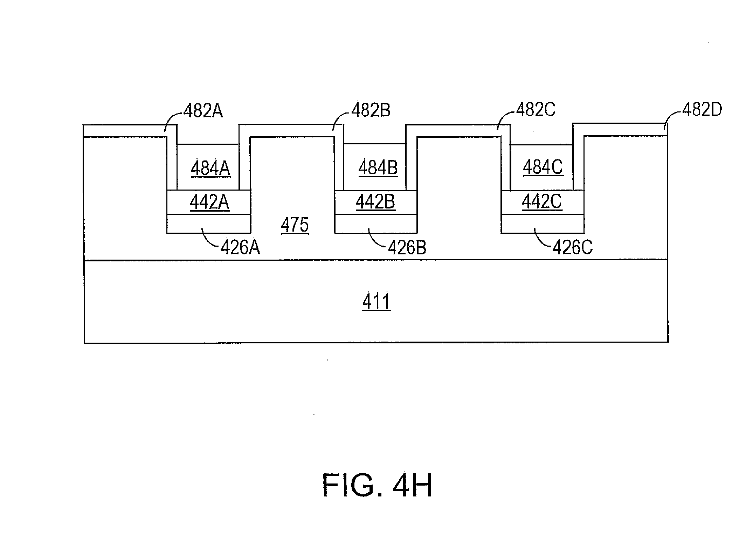

In FIG. 4H, after the second photoresist is stripped from the wafer's surface, a sacrificial oxide layer is grown thermally on the top of the oxide layers 442A-442C and 471A-471D. Then, the sacrificial oxide layer and the oxide layers 471A-471D are stripped away by wet buffered oxide etching (BOE) to remove surface defects and smooth surface roughness. Gate oxidation is performed surrounding the epi layer 475 to form gate oxide layers 482A-482D with a predetermined thickness. Then, poly film is deposited with doping in-situ or ex-situ to form polysilicon layers. The polysilicon layers are etched back with an end point mode. Hence, slight poly recess etching is performed to form polysilicon layers 484A-484C. As a result, the trenches are filled with the polysilicon layers 484A-484C with a predetermined thickness.

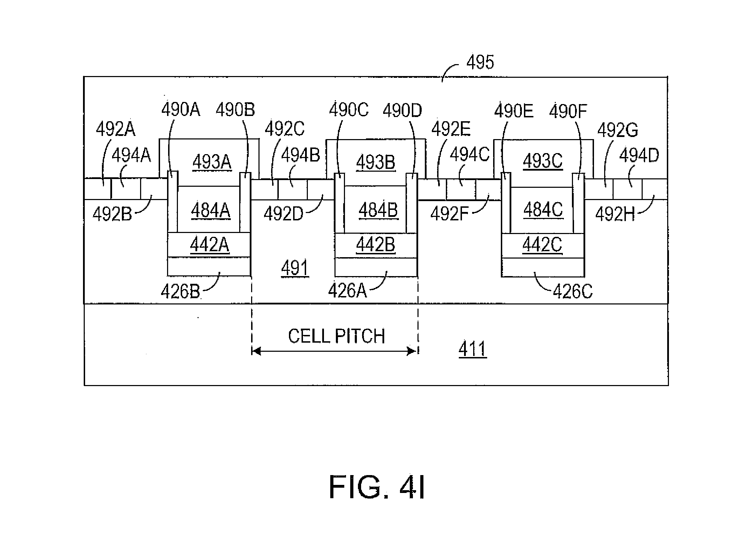

In FIG. 4I, P-type dopants or N-type dopants for the channel body (n-channel or p-channel trench MOSFET, respectively) are implanted and driven in the epi-layer 475 to form a P-well or N-well 491. The P-well or N-well 491 can form a body region of the trenches. Then, N-type dopants are implanted and driven in to form N+ layers 492A-492H. BPSG is deposited to form BPSG layers 493A-493C atop gate oxide layers 490A-490F. Subsequently, an implantation of P-type dopants followed by a drive-in step, an etching step, and an anneal step is performed to form P+ layers 494A-494D adjacent to the N+ layers 492A-492H. The N+ layers 492A-492H can form source regions of the trench MOSFET. Metallization is performed to separate gate and source metal connections. The entire trench MOSFET can be metalized by a metal layer 495. Then, passivation is performed to isolate the trench MOSFET from the external environment.

Advantageously, the parameters, e.g., the implant profile, shape and thickness, of each layer are easier to control during the upward fabrication processes of the trench MOSFET. The uniformity of trench depth etched by dry plasma with end point mode is improved because the TBO process is performed in the middle of the epi steps and before the trench etching step. Hence, extra fabrication steps are avoided, the cost of fabricating the trench MOSFET is reduced, and the quality and purity of each layer are improved.

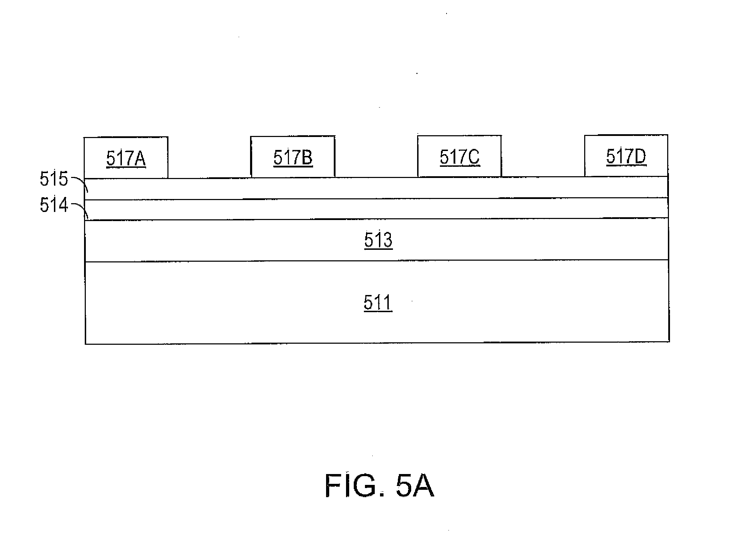

FIGs. 5A-5F illustrate cross-sectional views of a fabrication sequence of a trench MOSFET, in accordance with yet another embodiment of the present invention.

In FIG. 5A, epitaxial (epi) deposition is performed to form an epi layer 513 on the top of a semiconductor substrate 511 of a wafer. The semiconductor substrate 511 as a bottom layer can constitute a drain region of the trench MOSFET. The N-type heavily epi deposition or implantation is performed to form an N+ epi layer atop the epi layer 513. A partial thickness of the N+ epi layer is oxidized for a predetermined TBO thickness, e.g., 200-1000A. As a result, an oxide layer 515 is formed atop an N+ epi layer 514. Afterwards, a first photoresist is deposited to form photoresist regions 517A-517D. The photoresist regions 517A-517D act as soft masks to pattern trench areas for the trench MOSFET, e.g., the locations for the trenches of the trench MOSFET.

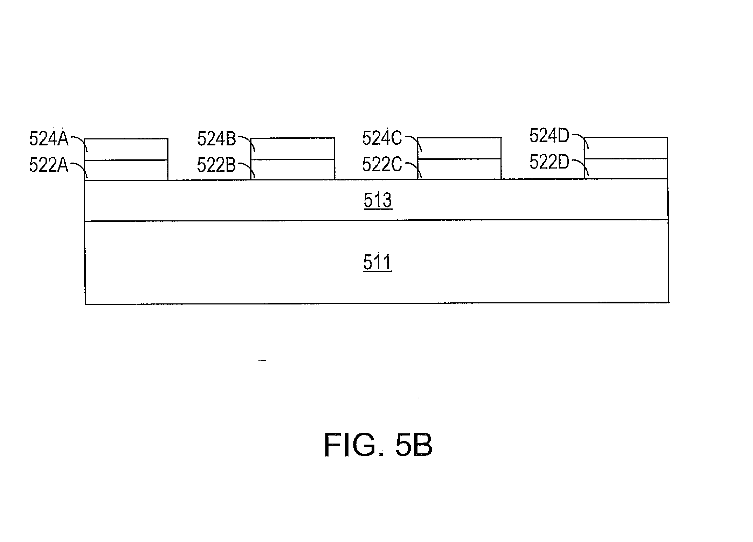

In FIG. 5B, oxide windows, e.g., part of the oxide layers 515, and silicon trenches, e.g., part of the N+ epi layer 514, are etched away to form oxide layers 524A-524D and N+ epi layers 522A-522D. Then the first photoresist is stripped away. Consequently, a TBD process and TBO process are performed in FIG. 5A-FIG. 5B.

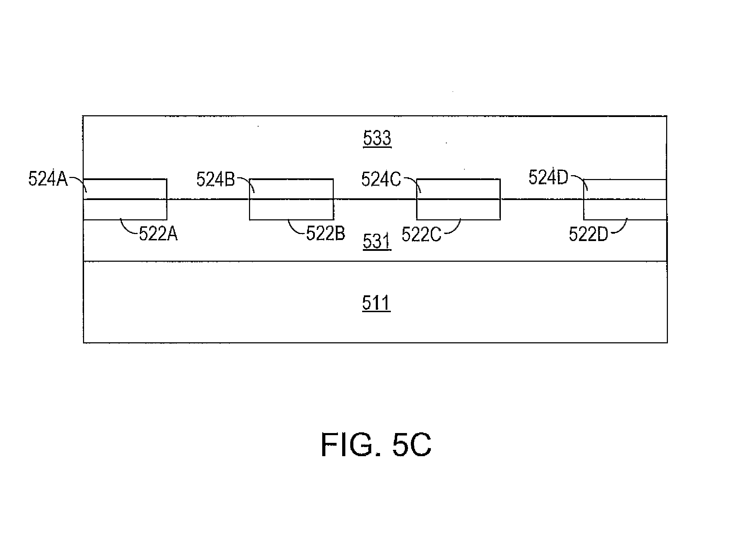

In FIG. 5C, a MELO step is performed to achieve the rest of the epi thickness of the trench MOSFET. As a result, due to the upward technology, the predetermined epi thickness for the trench MOSFET is easier to achieve to sustain a BV of the trench MOSFET. Epi layers 531 and 533 are formed to surround the N+ epi layers 522A-522D and the oxide layers 524A-524D.

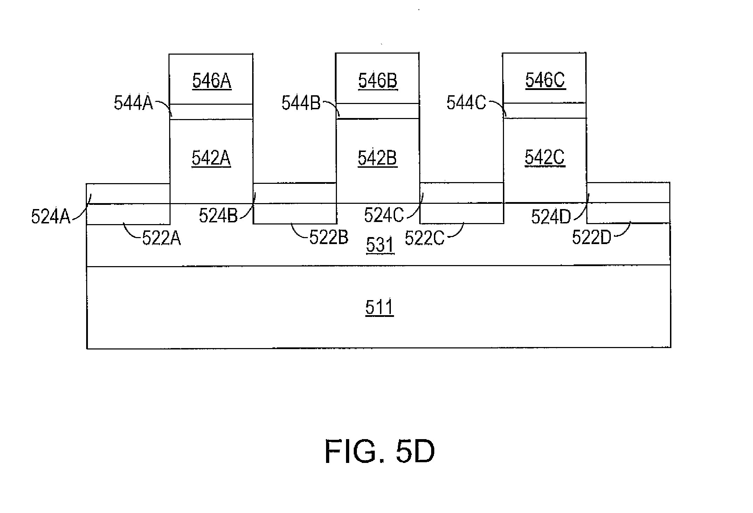

In FIG. 5D, hard mask oxidation is performed on the top of the epi layer 533 to form an oxide layer which is grown to about 200-1000A as hard mask oxide. Afterwards, a second photoresist is deposited to pattern the oxide layer, and photoresist regions 546A-546C are formed atop the oxide layer and pattern the locations for the trenches of the trench MOSFET. The edges of the photoresist regions 546A-546C are aligned to the edges of the oxide layers 524A-524D. Plasma dry etching with an end point mode is performed to remove the hard mask oxide and the silicon from part of the oxide layer and from part of the epi layer 533 to construct stacks of epi layers 542A-542C and oxide layers 544A-544C. Hence, the trenches for the trench MOSFET are formed.

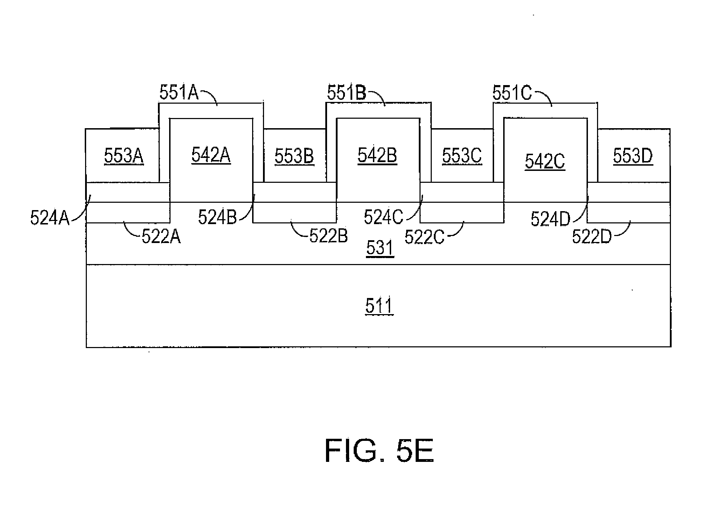

In FIG. 5E, after the second photoresist is removed from the wafer's surface, a sacrificial oxide layer is grown thermally on the top of the oxide layers 524A-524D and 544A-544C. Then the sacrificial oxide layer and the oxide layers 544A-544C are stripped away by wet buffered oxide etching (BOE) to remove surface defects and smooth surface roughness. Gate oxidation is performed surrounding the epi layers 542A-542C to form gate oxide layers 551A-551C with a predetermined thickness. Then, poly film is deposited with doping in-situ or ex-situ to form polysilicon layers. The polysilicon layers are etched back with an end point mode. Hence, slightlypoly recess etching is performed to form polysilicon layers 553A-553D. As a result, the trenches are filled with polysilicon layers 553A-553D with a predetermined thickness.

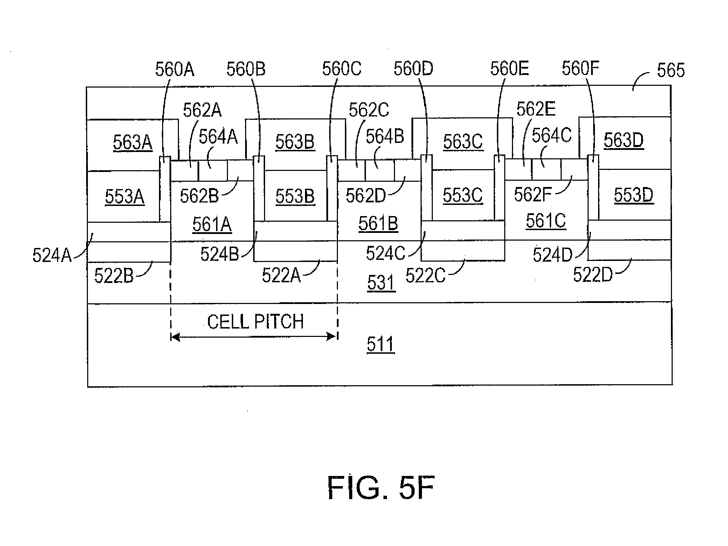

In FIG. 5F, P-type dopants or N-type dopants for the channel body (n-channel or p-channel trench MOSFET, respectively) are implanted and driven in the epi layers 542A-542C to form P-wells or N-wells 561A-561C. The P-wells or N-wells 561A-561C can form body regions of the trenches. Then, N-type heavily dopants are implanted and driven in to form N+ layers 562A-562F. BPSG is deposited to form BPSG layers 563A-563D atop gate oxide layers 560A-560F. Subsequently, an implantation of P-type dopants followed by a drive-in step, an etching step, and an anneal step is performed to form P+ layers 564A-564C adjacent to the N+ layers 562A-562F. The N+ layers 562A-562F can form source regions of the trench MOSFET. Metallization is performed to separate gate and source metal connections. The entire trench MOSFET can be metalized by a metal layer 565. Then, passivation is performed to isolate the trench MOSFET from the external environment.

Advantageously, the upward fabrication processes of the trench MOSFET make the parameters of each layer easier to control. The uniformity of trench depth etched by dry plasma with end point mode is improved because the TBO process is performed in the middle of the epi steps and before the trench etching step. As a result, extra fabrication steps are avoided, the cost of fabricating the trench MOSFET is reduced, and the quality and purity of each layer are improved.

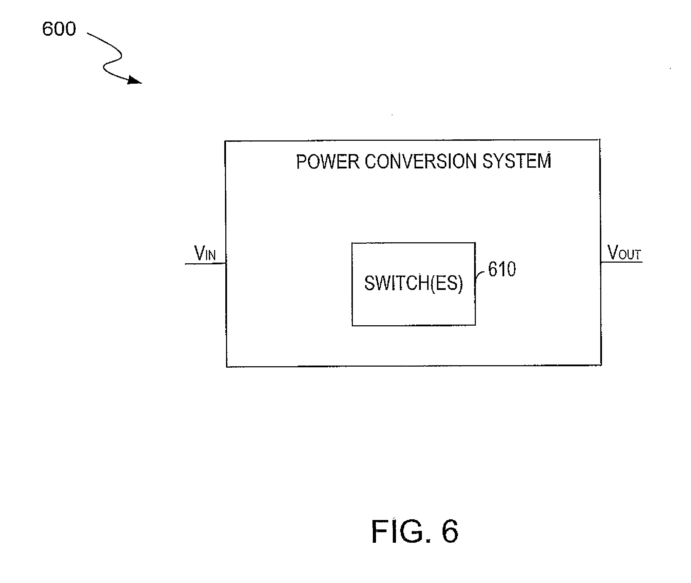

FIG. 6 illustrates a diagram of a power conversion system 600, in accordance with one embodiment of the invention. In one embodiment, the power conversion system 600 can converter an input voltage to an output voltage. For example, the power conversion system 600 can be a DC-DC converter, an AC-DC converter, or a DC-AC converter. The power conversion system 600 can include one or more switches 610.

In one embodiment, the switch 610 can be, but is not limited to, a trench MOSFET fabricated by the fabrication processes shown in FIGs. 2A-2F, FIGs. 3A-3I, FIGs. 4A-4I or FIG. 5A-5F. The switch 610 can be used as a high-side power switch or a low-side power switch in the power conversion system 600. Due to the improved uniformity and Si epi purity, and the reduced fabrication processes of the trench MOSFET, the switch 610 has relatively higher quality and lower cost. Switches fabricated by the above-mentioned processes will be in great demand for products such as notepads and smartphones for battery power management, DC-DC conversion, and so on.

In summary, a trench bottom doping (TBD) process and/or a trench bottom oxide (TBO) process are performed after formation of a substrate 211, 311, 411 or 511 and an epi layer 213, 313, 413 or 513. The substrate 211, 311, 411 or 511 constitutes a drain region of the trench MOSFET. A first photoresist is deposited and photoresist regions 217A-217D, 317A-317D, 417A-417D or 517A-517D are formed to act as soft masks to pattern the trench areas of the trench MOSFET. In one embodiment, N+ dopants are deposited into the trenches to form TBD layers, e.g., the N+ layers 426A-426C. Chemical vapor deposition (CVD) oxide or tetraethylorthosilicate (TEOS) is deposited and etched back to form the oxide layers 442A-442C atop the N+ layer 426A-426C. In another embodiment, N+ dopants are implanted to form the N+ epi layer, and a partial thickness of the N+ epi layer is oxidized to form the oxide layer 515 atop the N+ layer 514. The N+ epi layer 514 and the oxide layer 515 are etched to form TBD layers, e.g., the N+ epi layers 522A-522D, and the oxide layers 524A-524D. In yet another embodiment, a partial thickness of the epi layer is oxidized to form an oxide layer 215 atop the epi layer 213, and the oxide layer 215 is etched to form oxide layers 222A-222D. In yet another embodiment, a partial thickness of the epi layer is oxidized to form the oxide layer 315 atop the epi layer 313, and etching of the oxide layer 315 is performed. CVD oxide or TEOS is deposited and etched back to form the oxide layers 342A-342C. Advantageously, the TBO thickness can be increased without stress compared to that fabricated by the conventional LOCOS technology. For example, TBO layers, e.g., the oxide layers 222A-222D, 342A-342D, 442A-442C or 524A-524D can grow to greater than 5000A, while the TBO thickness is less than 3000A in the conventional LOCOS application.

After the TBD process and/or the TBO process are performed, a merged epitaxial lateral overgrowth (MELO) step is performed to grow the rest of the epi thickness of the trench MOSFET. Advantageously, it is easier to achieve a predetermined epi thickness of the trench MOSFET to sustain a breakdown voltage (BV) of the trench MOSFET. In one embedment, a poly seal step in FIG. 3E or in FIG. 4E is performed before the MELO step in FIG. 3F or FIG. 4F to improve the epi quality.

Afterwards, hard mask oxidation is performed, and a second photoresist patterns the locations for the trenches of the trench MOSFET. Trench etching is performed by plasma dry etching with an end point mode. More specifically, end points for plasma dry etching are preset according to the location of the TBO layers, e.g., the oxide layers 222A-222D, 342A-342C, 442A-442C or 524A-524D. In operation, the plasma dry etching is stopped when the etching location reaches the location of the TBO layers. Advantageously, the trench depth uniformity is improved by using the end point mode. Hence, silicon at the locations of the trenches is etched away and the trenches of the trench MOSFET are formed.

After the second photoresist is stripped away, a sacrificial oxidation is grown thermally, and sacrificial etching is performed to remove surface defects and smooth surface roughness. As a result, the oxide layers fabricated by the TBO process have better purity and better quality. Afterward, gate oxidization is performed. The thickness of the gate oxide in the lower part of the trenches is greater than 3000A, and the thickness of the gate oxide in the upper part of the trenches is between about 200A and 1000A. Then, poly film is deposited and etched back to achieve slight poly recession.

Subsequently, P-wells or N-wells for channel body (n-channel or p-channel trench MOSFET, respectively) are formed and constitute body regions of the trenches. Then, N+ layers are formed and constitute source regions of the trench MOSFET. Borophosphosilicate glass (BPSG) layers are formed atop the gate oxide layers. Subsequently, P+ layers are formed adjacent to the N+ layers. Metallization is performed to separate gate and source metal connections, and passivation is performed to isolate the trench MOSFET from the external environment.

While the foregoing description and drawings represent embodiments of the present invention, it will be understood that various additions, modifications and substitutions may be made therein without departing from the spirit and scope of the principles of the present invention as defined in the accompanying claims. One skilled in the art will appreciate that the invention may be used with many modifications of form, structure, arrangement, proportions, materials, elements, and components and otherwise, used in the practice of the invention, which are particularly adapted to specific environments and operative requirements without departing from the principles of the present invention. The presently disclosed embodiments are therefore to be considered in all respects as illustrative and not restrictive, the scope of the invention being indicated by the appended claims and their legal equivalents, and not limited to the foregoing description.

## Claims

1. A method for fabricating a trench metal oxide semiconductor field effect transistor (MOSFET) in an upward direction, comprising:
forming a first epitaxial (epi) layer atop a substrate;
forming a plurality of trench bottom oxide (TBO) layers in a plurality of trench areas atop said first epi layer and after formation of said first epi layer;
growing a second epi layer by a merged epitaxial lateral overgrowth (MELO) step atop said plurality of TBO layers and after formation of said plurality of TBO layers; and
etching part of said second epi layer by plasma dry etching with an end point mode according to locations of said plurality of TBO layers to form a plurality of trenches for said trench MOSFET.

2. The method of claim 1, further comprising:
depositing poly film in said plurality of trench areas to form a plurality of polysilicon layers atop said plurality of TBO layers and below said second epi layer.

3. The method of claim 1 or 2, further comprising:
forming an N-type heavily doped (N+) layer atop said first epi layer; and
etching part of said N+ layer in said plurality of trench areas to form a plurality of trench bottom doping (TBD) layers atop said first epi layer and below said plurality of TBO layers.

4. The method of claim 1 or 2, further comprising:
depositing N-type heavily doped (N+) materials in said plurality of trench areas to form a plurality of trench bottom doping (TBD) layers atop said first epi layer and below said plurality of TBO layers.

5. The method of one of claims 1 to 4, wherein said first epi layer grows part of a predetermined epi thickness and said second epi layer grows the rest of said predetermined epi thickness.

6. The method of one of claims 1 to 5, further comprising:
forming a first oxide layer atop said second epi layer;
depositing a photoresist atop said first oxide layer to pattern said plurality of trench areas, wherein edges of said photoresist are aligned to edges of said plurality of TBO layers;
etching part of said first oxide layer in said plurality of trench areas by said plasma drying etching with said end point mode; and
removing said photoresist after formation of said plurality of trenches.

7. The method of claim 6, further comprising:
growing a sacrificial oxide layer atop said plurality of TBO layers and the rest of said first oxide layer; and
removing said sacrificial oxide layer and said rest of said first oxide layer by wet buffered oxide etching (BOE).

8. The method of one of claims 1 to 7, further comprising:
forming a plurality of gate oxide layers to surround the rest of said second epi layer;
forming a plurality of polysilicon layers in said plurality of trench areas; and
etched said plurality of polysilicon layers back with said end point mode to fill said plurality of trenches for said trench MOSFET.

9. The method of claim 8, further comprising:
implanting and driving dopants in the rest of said second epi layer to form a body region of said trenches;
implanting and driving N-type dopants to form a plurality of N-type heavily doped (N+) layers;
depositing Borophosphorosilicate glass (BPSG) to form a plurality of BPSG layers atop said gate oxide layers; and
driving-in and implanting P-type dopants to form a plurality of P-type heavily doped (P+) layers adjacent to said plurality of N+ layers.

10. The method of one of claims 1 to 9, further comprising:
etching away part of a second oxide layer atop said first epi layer to form said plurality of TBO layers.

11. The method of one of claims 1 to 10, further comprising:
depositing chemical vapor deposition (CVD) oxide to form a third oxide layer atop said first epi layer; and
etching back said third oxide layer with said end point mode to form said plurality of TBO layers.

12. The method of one of claims 1 to 10, further comprising:
depositing tetraethylorthosilicate (TEOS) to form a third oxide layer atop said first epi layer; and
etching back said third oxide layer with said end point mode to form said plurality of TBO layers.
